# EUROPEAN PATENT APPLICATION

(11) **EP 1 630 565 A1**
(43) Date of publication of application: **01.03.2006**
(21) Application number: 05255061.3
(22) Date of filing: 16.08.2005
(51) Int. Cl.: G01R 31/00

(54) **A method of detecting an arcing event and a printing machine using said method**

(30) Priority: 23.08.2004 US 924045
(71) Applicant: Xerox Corporation, Rochester, New York 14644 (US)
(72) Inventor: Wayman, William H., Ontario, NY 14519 (US); Lux, Richard A., Webster, NY 14580 (US)
(74) Representative: Skone James, Robert Edmund

(57) **Abstract**

A printing machine (100) is arranged to detect an arcing event. An arcing detection signal (231) based on the arcing event is formed. The arcing detection signal includes an arcing detection signal frequency and an arcing detection signal amplitude. The arcing detection signal frequency value and the arcing detection signal amplitude value are used to detect the occurrence of an arcing event. Once an arcing event is detected, an arcing level corresponding to the severity of the arcing event is determined. At least one arcing remedy based on the arcing level then is performed. The arcing remedy comprises any of logging the arcing event, generating a maintenance message, performing a maintenance procedure, informing a maintenance person, dispatching a maintenance person and powering-down the printing machine.

## Description

Modern printing machines such as "iGen" can have a high rate of spurious corona or "arcing" induced faults. Arcing generates radio frequency ("RF") noise that can couple into machine signals and interfere with machine logic and control systems. Spurious discharges associated with the corona charging systems radiate RF from the fast rise/fall times of the associated currents. Arcing can occur in the charging device (dicorotron) but is more troublesome in the high-voltage ("HV") connectors, wiring and associated power supplies. For example, in iGen there are 11 separate HV supplies feeding 18 corona devices. Further, radiated RF noise can result in communication faults or machine clock timing errors. Timing errors can cause process controls patch read errors and associated color shifts or faults.

Diagnosing arcing problems is currently difficult due to the large number of HV wires and connectors in iGen. Many of these wires and connectors are difficult to see or access for troubleshooting purposes. As a result, it is not uncommon for a machine with arcing problems to have long service calls lasting several days. Moreover, many perfectly good parts are replaced in an attempt to isolate the arcing problem and fix the machine.

Furthermore, as machine parts age, "grounding" brushes can wear out which, in turn, will allow associated parts to charge up and arc. These failures are usually intermittent and frustrating to diagnose.

Possible machine arcing sources are listed as follows: corona devices; HV connectors; breakdown around HV wiring; intermittent bias brush connections to cleaner brushes; intermittent bias brush connections to developer rolls; arcing in toner waste systems, including ducts, manifolds, waste bottles, cyclone separators, etc.; paper path components; and arcing in the developer system, including toner charging of conductive, electrically-isolated development system components.

In accordance with the present invention, we provide a printing machine and method of detecting an arcing event in a printing machine, the method comprising:
(a) forming an arcing detection signal that is based on the arcing event, the arcing detection signal comprising an arcing detection signal frequency value and an arcing detection signal amplitude value;
(b) determining when an arcing event has occurred based on the arcing detection signal frequency value and the arcing detection signal amplitude value; and,
(c) determining an arcing level corresponding to the arcing event.

Some examples of printing machines and methods according to the present invention will now be described with reference to the accompanying drawings, in which:-
FIG. 1 depicts a printing machine 100 arranged to form an arcing detection signal 231 based on a radio frequency signal 211. The arcing detection signal 231 is then used to detect an arcing event based on an included method 300 or method 400.
FIG. 2 depicts the printing machine 100 arranged to form an arcing detection signal 261 based on a serial command bus signal 251. The arcing detection signal 261 is then used to detect an arcing event based on an included method 300 or method 400.
FIG. 3 depicts one embodiment of a flow diagram of the method 300 of detecting an arcing event in the printing machine 100.
FIG. 4 depicts one embodiment of a flow diagram of the method 400 of detecting an arcing event in the printing machine 100.
FIG. 5 depicts one embodiment of a functional relationship 500 of arcing detection signal amplitude values and corresponding arcing levels that is used with the method 400 and is also optionally used with the method 300. As shown, the arcing detection signal amplitude values are plotted on the horizontal or "X" axis. Also, the corresponding arcing levels are plotted on the vertical or "Y" axis. As shown, each arcing level on the Y axis comprises one of a group of N predetermined arcing levels, where N equals 3. Thus, the functional relationship 500 comprises exactly three (3) arcing levels designated "Level 1 ", "Level 2" and "Level 3". Note that arcing levels are defined only for those arcing detection signal amplitude values that are greater than A₀.
FIG. 6 depicts one embodiment of a service diagnostic method 600 to diagnose arcing in the various high-voltage ("HV") devices or groups of HV devices comprised in the printing machine 100. The method 600 utilizes either the method 300 or the method 400.

Briefly, a printing machine is arranged to detect an arcing event. An arcing detection signal based on the arcing event is formed. The arcing detection signal includes an arcing detection signal frequency and an arcing detection signal amplitude. The arcing detection signal frequency value and the arcing detection signal amplitude value are used to detect the occurrence of an arcing event. Once an arcing event is detected, an arcing level corresponding to the severity of the arcing event is determined. At least one arcing remedy based on the arcing level then is performed. The arcing remedy comprises any of logging the arcing event, generating a maintenance message, performing a maintenance procedure, informing a maintenance person, dispatching a maintenance person and powering-down the printing machine. In one embodiment, the method is used to diagnose arcing problems in the printing machine.

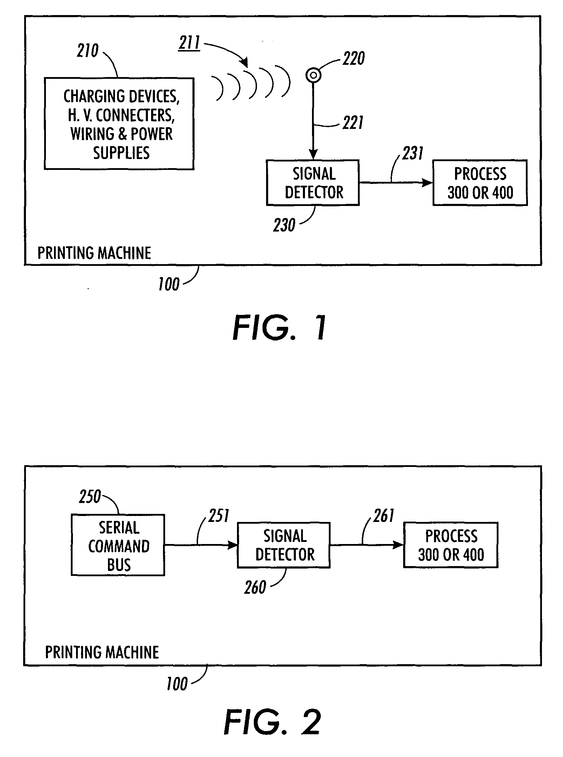

Referring now to FIG. 1, there is depicted a printing machine 100. Included charging devices, high-voltage connectors, wiring and power supplies 210 emit a radio frequency signal 211. The radio frequency signal 211 is received by an antenna 220 and, in turn, provided 221 to a signal detector 230. The signal detector 230, in turn, forms an arcing detection signal 231. The printing machine 100 uses the arcing detection signal 231 to determine when an arcing event has occurred based on an included method 300 or method 400.

Referring still to FIG. 1, in one embodiment, the signal detector 230 comprises any detecting means that is suitable for detecting the frequency and amplitude of the radio frequency signal 211. In one embodiment, the signal detector 230 comprises either a high-pass filter or a band-pass filter to block all normal machine frequencies and pass only the arcing frequencies coupled with an amplitude peak-hold function. In one embodiment, the antenna 220 comprises an existing wire in the harness chosen for its proximity to any likely arcing sources or else an additional antenna wire dedicated to arc signal detection.

Referring now to FIG. 2, there is depicted the FIG. 1 printing machine 100. An included serial command bus 250 forms a serial command bus signal 251. The serial command bus 250 acts as an antenna to receive the radio frequency signal 211 that is depicted in FIG. 1. As a result, the radio frequency signal 211 is comprised in the serial command bus signal 251. The serial command bus signal 251 is provided to a signal detector 260. The signal detector 260, in turn, forms an arcing detection signal 261. The printing machine 100 uses the arcing detection signal 261 to determine when an arcing event has occurred based on the included method 300 or method 400.

Referring still to FIG. 2, in one embodiment, the signal detector 260 comprises any detecting means that is suitable for detecting the frequency and amplitude of the radio frequency signal 211 as comprised in the serial command bus signal 251. In one embodiment, the signal detector 260 comprises either a high-pass filter or a band-pass filter to block all normal machine frequencies and pass only the arcing frequencies coupled with an amplitude peak-hold function.

Referring now generally to FIGS. 1 and 2, in various embodiments the printing machine 100 comprises any of a copier, a network printer and a facsimile device.

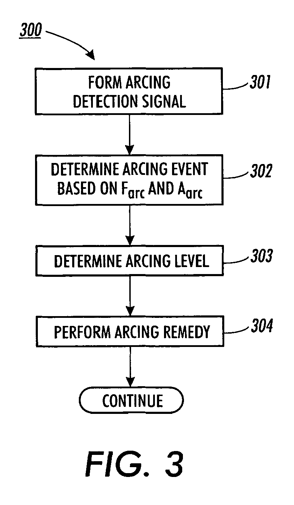

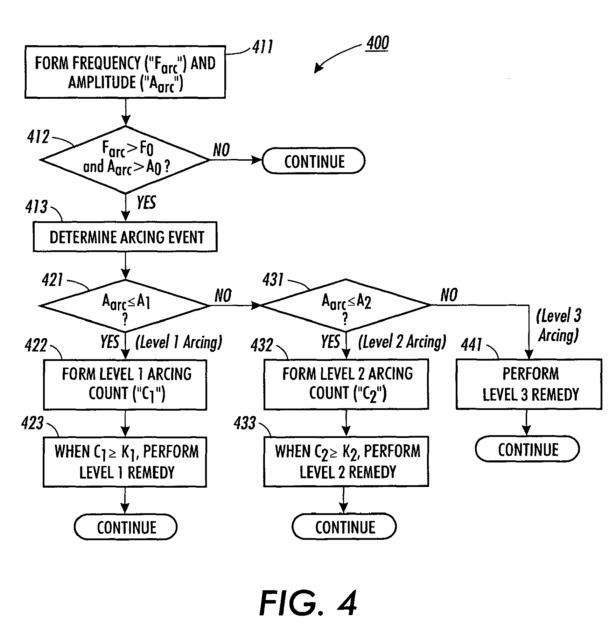

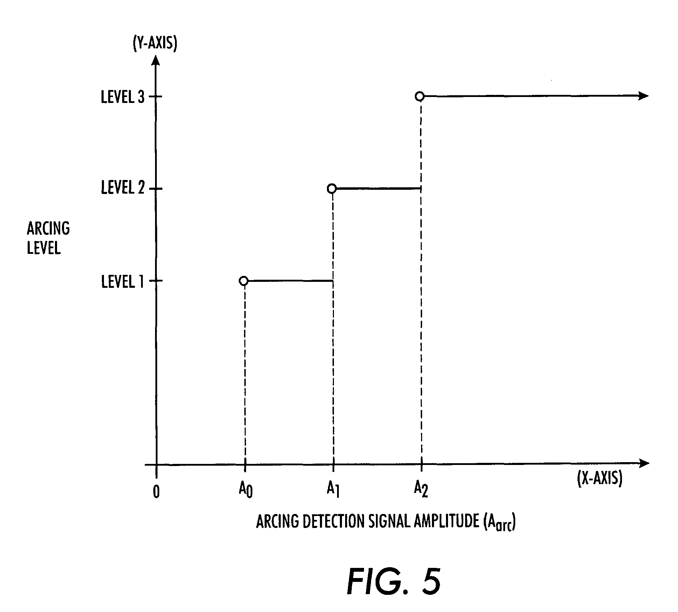

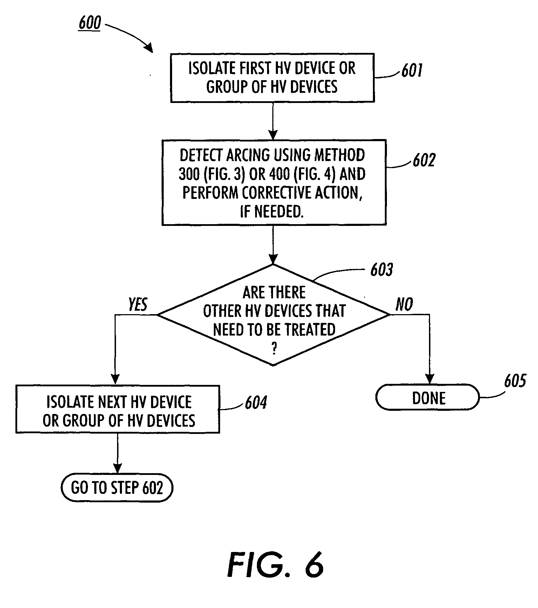

Referring now to FIG. 3, there is depicted one embodiment of a flow diagram of the method 300 of detecting an arcing event in the printing machine 100. As shown, the method or process 300 comprises the steps designated 301 through 304.

The process starts at step 301. In step 301, the process forms an arcing detection signal (depicted as element 231 in FIG. 1 and depicted as element 261 in FIG. 2) that is based on the arcing event, the arcing detection signal comprising an arcing detection signal frequency value ("F_{arc}") and an arcing detection signal amplitude value ("A_{arc}").

Still referring to step 301, with momentary cross-reference to FIG. 1, in one embodiment the printing machine 100 includes high-voltage apparatus 210 that generates a radio frequency signal 211 based on the arcing event and, accordingly, the step 301 of forming the arcing detection signal 231 includes detecting the radio frequency signal 211 by means of the included signal detector 230.

Still referring to step 301, with momentary cross-reference to FIG. 2, in one embodiment the printing machine 100 includes a serial command bus 250 that provides a serial command bus signal 251 based on the arcing event and, accordingly, the step 301 of forming the arcing detection signal 261 includes detecting the serial command bus signal 251 by means of the included signal detector 260.

After step 301, the process goes to step 302.

In step 302, the process determines when an arcing event has occurred based on the arcing detection signal frequency value and the arcing detection signal amplitude value. For example, in one embodiment step 302 is similar to steps 412 and 413 which are described in connection with FIG. 4 below. The process then goes to step 303.

In step 303, the process determines an arcing level corresponding to the arcing event. The arcing level generally characterizes the severity of the arcing event.

Still referring to step 303, in one embodiment, for example, the arcing level is based on the arcing detection signal amplitude value.

In one embodiment, the arcing level comprises one of a group of N predetermined arcing levels, where N is an integer equal to or greater than 1.

In one embodiment, the group of N predetermined arcing levels comprises exactly one (1) arcing level, thus N equals 1.

In one embodiment, the group of N predetermined arcing levels comprises exactly two (2) arcing levels, thus N equals 2.

In one embodiment, the group of N predetermined arcing levels comprises exactly three (3) arcing levels, thus N equals 3. For example, in one embodiment the group of predetermined arcing levels and corresponding arcing detection signal amplitude values are based on the functional relationship 500 that is described in connection with FIG. 5.

Still referring to step 303, in one embodiment the group of N predetermined arcing levels comprises four (4) or more arcing levels, thus N is equal to or greater than 4.

After step 303, the process goes to step 304.

In step 304, the process performs at least one arcing remedy based on the arcing level determined in step 303. In various embodiments of the step 304, the at least one arcing remedy comprises any of logging the arcing event, generating a maintenance message, performing a maintenance procedure, informing a maintenance person, dispatching a maintenance person and powering-down the printing machine.

Referring generally to FIG. 3, in one embodiment the process 300 is used to diagnose arcing problems in the printing machine 100. In this embodiment, with momentary cross-reference to FIG. 6, the process 300 includes a preceding step 601 of enabling only a particular high-voltage ("HV") device or group of HV devices comprised in the printing machine 100, with the remaining HV devices comprised in the printing machine being disabled. The step 601 is described in connection with FIG. 6 below.

Referring now to FIG. 4, there is depicted one embodiment of a flow diagram of the method 400 of detecting an arcing event in the printing machine 100. As shown, the method or process 400 comprises the steps designated 411 through 441

The process starts at step 411. In step 411, the process forms an arcing detection signal (depicted as element 231 in FIG. 1 and depicted as element 261 in FIG. 2) that is based on the arcing event, the arcing detection signal comprising an arcing detection signal frequency value ("F_{arc}") and an arcing detection signal amplitude value ("A_{arc}").

Still referring to step 411, with momentary cross-reference to FIG. 1, in one embodiment the printing machine 100 includes high-voltage apparatus 210 that generates a radio frequency signal 211 based on the arcing event and, accordingly, the step 411 of forming the arcing detection signal 231 includes detecting the radio frequency signal 211 by means of the included signal detector 230.

Still referring to step 411, with momentary cross-reference to FIG. 2, in one embodiment the printing machine 100 includes a serial command bus 250 that provides a serial command bus signal 251 based on the arcing event and, accordingly, the step 411 of forming the arcing detection signal 261 includes detecting the serial command bus signal 251 by means of the included signal detector 260.

After step 411, the process goes to step 412.

In step 412 the process determines when the arcing detection signal frequency value exceeds a predetermined arcing frequency threshold ("F₀") and the arcing detection signal amplitude value exceeds a predetermined arcing amplitude threshold ("A₀"). When the result of this determination is positive (depicted as "YES" in step 412), the process goes to step 413.

In step 413, based on the positive determination of step 412, that is, that the arcing detection signal frequency value exceeds the arcing frequency threshold and the arcing detection signal amplitude value exceeds the arcing amplitude threshold, the process determines that an arcing event has occurred. The process then goes to step 421.

Referring generally to steps 421 and 431, with cross-reference to the functional relationship 500 as depicted in FIG. 5, it will be understood that steps 421 and 431 act to determine an arcing level based on the arcing detection signal amplitude value. In particular, these steps 421 and 431 determine an arcing level wherein the arcing level comprises one of a group of N predetermined arcing levels, where N equals 3. The resulting three (3) predetermined arcing levels and their corresponding arcing detection signal amplitude values are depicted in FIG. 5.

Referring to step 421, with cross-reference to FIG. 5, the arcing level is determined to be a first arcing level (depicted as "Level 1" in FIG. 5) when the step 421 determines that the arcing detection signal amplitude value ("A_{arc}") is less than or equal to a first threshold ("A₁"), where the first threshold is greater than the arcing amplitude threshold ("A₀"). For good understanding of step 421, recall that the previous step 412 already has determined that the arcing detection signal amplitude value ("A_{arc}") exceeds the predetermined arcing amplitude threshold ("A₀"). The process then goes to step 422.

Still referring to step 421, when the step 421 determines that the arcing detection signal amplitude value is NOT less than or equal to the first threshold ("A₁") and, as a result, that the arcing detection signal amplitude value exceeds the first threshold, the process goes to step 431.

In step 431, the arcing level is determined to be a second arcing level (depicted as "Level 2" in FIG. 5) when the step 431 determines that the arcing detection signal amplitude value ("A_{arc}") is less than or equal to a second threshold ("A₂"), where the second threshold is greater than the first threshold ("A₁"). The process then goes to step 432.

Still referring to step 431, the arcing level is determined to be a third arcing level (depicted as "Level 3" in FIG. 5) when the step 431 determines that the arcing detection signal amplitude value ("A_{arc}") is NOT less than or equal to the second threshold ("A₂") and, as a result, that the arcing detection signal amplitude value exceeds the second threshold. The process then goes to step 441.

Returning to step 421, when step 421 determines the arcing level to be the first arcing level (Level 1), the process goes to step 422.

In step 422, the process forms a first level arcing event count ("C₁") corresponding to a count of the number of occurrences of a first level arcing event. For good understanding, a first level arcing event is defined as an arcing event whose arcing level is determined to be the first arcing level (Level 1). The process then goes to step 423.

In step 423, the process determines when the first level arcing event count ("C₁") at least equals a first level arcing event count threshold ("K₁") corresponding to the first arcing level and, when it is determined that the first level arcing event count at least equals the first level arcing event count threshold, the step 423 performs at least one arcing remedy based on the first arcing level. In one embodiment, the at least one arcing remedy comprises any of logging the arcing event, generating a maintenance message, performing a maintenance procedure, informing a maintenance person, dispatching a maintenance person and powering-down the printing machine.

Returning to step 431, when step 431 determines the arcing level to be the second arcing level (Level 2), the process goes to step 432.

In step 432, the process forms a second level arcing event count ("C₂") corresponding to a count of the number of occurrences of a second level arcing event. For good understanding, a second level arcing event is defined as an arcing event whose arcing level is determined to be the second arcing level (Level 2). The process then goes to step 433.

In step 433, the process determines when the second level arcing event count ("C₂") at least equals a second level arcing event count threshold ("K₂") corresponding to the second arcing level and, when it is determined that the second level arcing event count at least equals the second level arcing event count threshold, the step 433 performs at least one arcing remedy based on the second arcing level. In one embodiment, the at least one arcing remedy comprises any of logging the arcing event, generating a maintenance message, performing a maintenance procedure, informing a maintenance person, dispatching a maintenance person and powering-down the printing machine.

Returning to step 431, when step 431 determines the arcing level to be the third arcing level (Level 3), then a third level arcing event has occurred. For good understanding, a third level arcing event is defined as an arcing event whose arcing level is determined to be the third arcing level. The process then goes to step 441.

In step 441, the process provides at least one arcing remedy based on the third arcing level. In one embodiment, the at least one arcing remedy comprises any of logging the arcing event, generating a maintenance message, performing a maintenance procedure, informing a maintenance person, dispatching a maintenance person and powering-down the printing machine.

Referring generally to FIG. 4, in one embodiment the process 400 is used to diagnose arcing problems in the printing machine 100. In this embodiment, with momentary cross-reference to FIG. 6, the process 400 includes a preceding step 601 of enabling only a particular high-voltage ("HV") device or group of HV devices comprised in the printing machine 100, with the remaining HV devices comprised in the printing machine being disabled. The step 601 is described in connection with FIG. 6 below.

Referring now to FIG. 6, there is depicted one embodiment of a service diagnostic method 600 to diagnose arcing in the various high-voltage ("HV") devices or groups of HV devices comprised in the printing machine 100. The method 600 utilizes either the method 300 of FIG. 3 or the method 400 of FIG. 4.

As shown, the method or process 600 comprises the steps designated 601 through 605.

In step 601, a first HV device or group of HV devices in the printing machine 100 is isolated, meaning that only these HV devices are enabled, with the remaining HV devices in the printing machine 100 being disabled.

In step 602, arcing is detected in the isolated HV device(s) using either method 300 or method 400 and, if needed, corrective action is performed.

In steps 603 and 604, the foregoing testing process is then repeated with respect to the remaining HV devices in the printing machine 100 until all HV devices are tested.

The testing is then complete, step 605.

In one embodiment, the present invention automatically detects arcing by using an arcing detection signal detector circuit connected to an in-machine antenna. The machine CPU monitors the arcing detection signal. In one embodiment, for low (harmless) levels of arcing, this arcing detection signal is used to activate log-only faults, while for higher levels of arcing, shutdown faults are triggered.

In one embodiment, the arc detector is used with a service diagnostic routine. In this embodiment, the tech-rep individually enables the corona devices and notes when arcing is detected and at which levels. Arcing associated with the turn-on of a specific device indicates a problem in that device or associated wiring or power supply. To save time it is possible to half-split the devices by turning on half the total charging devices and then half again depending on the arcing result. These routines can be manual in operation or else automated in software. Also, these routines can be run periodically, or at every cycle up, or only as a manual diagnostic routine by the tech-rep.

Referring again to FIG. 1, in one embodiment, the signal detector 230 comprises an RF amplifier circuit with a high-frequency pass band well above any normal machine frequencies. The signal detector 230 can include a peak-hold function, enabling only periodic monitoring by the CPU of the signal.

In one embodiment of the present invention, a VHF (50-450 MHz) amplifier is connected to an antenna wire positioned in the power supply area of the print engine. The amplifier output is connected to a diode and a capacitor to rectify and peak-hold the signal. Arcing events are induced and the resulting signal is captured on a digital oscilloscope and displayed for analysis.

Some advantages of the present invention are now discussed. One advantage of the present invention is that it enables the service time and effort required to diagnose arcing in the printing machine to be substantially reduced. Thus, by automatically detecting an arcing condition in the printing machine, the present invention thereby enables quick isolation of the corresponding defective wiring, parts, or connectors. Accordingly, one key business advantage of the present invention is that it substantially reduces both the quantity and duration of the printing machine down times. Another key business advantage of the present invention is that it results in substantially simpler and therefore less expensive service calls by maintenance personnel. Both of these business advantages, of course, translate into increased productivity of the printing machine itself. Moreover, by increasing the productivity of the printing machine, the invention thereby enables the printing machine user to decrease its corresponding production costs, thus translating into higher profit levels for the user's printing service.

Thus, there has been described the first aspect of the invention, namely, the method 300 of detecting an arcing event in a printing machine 100, the method comprising (a) in step 301, forming an arcing detection signal that is based on the arcing event, the arcing detection signal comprising an arcing detection signal frequency value ("F_{arc}") and an arcing detection signal amplitude value ("A_{arc}"); (b) in step 302, determining when an arcing event has occurred based on the arcing detection signal frequency value and the arcing detection signal amplitude value; (c) in step 303, determining an arcing level corresponding to the arcing event; and (d) in step 304, performing at least one arcing remedy based on the arcing level.

Also, there has been described the second aspect of the invention, namely, the method 400 of detecting an arcing event in a printing machine 100, the method comprising (a) in step 411, forming an arcing detection signal (any of elements 231 and 261) that is based on the arcing event, the arcing detection signal comprising an arcing detection signal frequency value ("F_{arc}") and an arcing detection signal amplitude value ("A_{arc}"); (b) in step 412, determining when the arcing detection signal frequency value exceeds a predetermined arcing frequency threshold ("F₀") and the arcing detection signal amplitude value exceeds a predetermined arcing amplitude threshold ("A₀"); and (c) in step 413, when the arcing detection signal frequency value exceeds the arcing frequency threshold and the arcing detection signal amplitude value exceeds the arcing amplitude threshold, determining that an arcing event has occurred.

## Claims

1. A method of detecting an arcing event in a printing machine, the method comprising:
(a) forming an arcing detection signal that is based on the arcing event, the arcing detection signal comprising an arcing detection signal frequency value and an arcing detection signal amplitude value;
(b) determining when an arcing event has occurred based on the arcing detection signal frequency value and the arcing detection signal amplitude value; and,
(c) determining an arcing level corresponding to the arcing event.

2. A method according to claim 1, wherein steps (b) and (c) comprise determining when the arcing detection signal frequency value exceeds a predetermined arcing frequency threshold and the arcing detection signal amplitude value exceeds a predetermined arcing amplitude threshold; and when the arcing detection signal frequency value exceeds the arcing frequency threshold and the arcing detection signal amplitude value exceeds the arcing amplitude threshold, determining that an arcing event has occurred.

3. The method of claim 1 or claim 2, including determining an arcing level based on the arcing detection signal amplitude value.

4. The method of claim 2, where the arcing level comprises one of a group of N predetermined arcing levels, where N is an integer equal to or greater than 1.

5. A method according to any of the preceding claims, further comprising:
(d) performing at least one arcing remedy.

6. The method of claim 5, when dependent on claim 3 or claim 4, including performing at least one arcing remedy based on the arcing level.

7. The method of claim 5 or claim 6, the at least one arcing remedy comprising any of logging the arcing event, generating a maintenance message, performing a maintenance procedure, informing a maintenance person, dispatching a maintenance person and powering-down the printing machine.

8. The method of any of the preceding claims, the printing machine including high-voltage apparatus that generates a radio frequency signal based on the arcing event, the step (a) of forming the arcing detection signal including a step of detecting the radio frequency signal.

9. The method of any of claims 1 to 7, the printing machine including a serial command bus that provides a serial command bus signal based on the arcing event, the step (a) of forming the arcing detection signal including a step of detecting the serial command bus signal.

10. The method of any of the preceding claims, including a preceding step of enabling only a particular high-voltage ("HV") device or group of HV devices comprised in the printing machine, with the remaining HV devices comprised in the printing machine being disabled.

11. A printing machine adapted to perform a method according to any of the preceding claims.

12. A printing machine according to claim 11, the printing machine comprising one of a copier, a network printer and a facsimile device.
